# EUROPEAN PATENT SPECIFICATION

(11) **EP 0 506 926 B1**
(45) Date of publication and mention of the grant of the patent: **19.03.1997**
(21) Application number: 91918988.6
(22) Date of filing: 20.09.1991
(51) Int. Cl.: H01L 21/225, H01L 31/18, B05B 7/00

(54) **METHOD AND APPARATUS FOR FORMING DIFFUSION JUNCTIONS IN SOLAR CELL SUBSTRATES**
VERFAHREN UND VORRICHTUNG ZUM HERSTELLEN VON ÜBERGÄNGEN DURCH DIFFUSION IN SUBSTRATE VON SOLARZELLEN
METHODE ET APPAREIL SERVANT A FORMER DES JONCTIONS PAR DIFFUSION DANS DES SUBSTRATS DE CELLULES SOLAIRES

(30) Priority: 24.10.1990 US 604000
(43) Date of publication of application: 07.10.1992
(73) Proprietor: ASE AMERICAS, INC., Billerica, MA 01821 (US)
(72) Inventor: ROSENBLUM, Mark, D., Woburn, MA 01801 (US); HANOKA, Jack, I., Brookline, MA 02146 (US)
(74) Representative: Lemoine, Robert
(86) International application number: US9106843
(87) International publication number: WO9208245

(56) References cited:
- US-A- 4 273 950
- US-A- 4 360 393
- US-A- 4 836 137
- Integrated Technology, Inc., brochure (2 pages), entitled, "PM 2000 Spray Coating & Drying".
- H.L. BERGER, "Ultrasonic Nozzles Atomized Without Air", Machine Design, 6 pages, July 1988.

## Description

This invention pertains to the manufacture of photovoltaic cells, and more particularly to an improved method for producing photovoltaic junctions by diffusion that offers the advantage of cost savings with no loss of reliability or conversion efficiency.

### PRIOR ART

It is well known that attainment of the object of producing commercially-acceptable silicon solar cells with a relatively high efficiency and at a relatively low cost is not expected to occur as a result of a spectacular breakthrough in a single area; rather persons skilled in the art appreciate that the goal of providing economically and technically acceptable photovoltaic solar cells may be achieved as a consequence of the combined effect of a number of what appear to be relatively modest but innovative advances in the art. Thus what may appear to be a relatively small technological advance in a specific area of the photovoltaic cell art may in fact be quite significant from the standpoint of achieving cost savings while permitting the production of relatively high efficiency solar cells.

Currently, and for a number of years preceding the present invention, great efforts have been expended in devising methods of manufacturing solar cells so as to achieve the objectives of (1) relatively high energy conversion efficiency and power output, (2) high production yield, and (3) low cost. Additionally there has been great concern in providing solar cells which are reliable and which do not degrade readily in the operating environment.

One effort directed to the manufacture of relatively low cost silicon cells has involved the production and use of flat polycrystalline silicon substrates grown by the EFG process. Other efforts have involved use of cast polycrystalline substrates, dendritic web silicon substrates, or substrates that are more nearly a single crystal material, e.g., substrates formed by sub-dividing Czochralski-grown boules. In any event, regardless of the source of the substrate, certain steps are required to be carried out in order to convert a silicon substrate into an operative photovoltaic solar cell. In particular, a photovoltaic junction must be formed adjacent one surface of the substrate. In the case of EFG-grown substrates, the substrates are typically of p-type conductivity, preferably being doped with boron so as to have a conductivity in the range of about 2-3 ohm-cm. Accordingly, an n-type dopant, e.g., phosphorus, must be introduced into one side of the substrate in order to form a photovoltaic semiconductor junction.

The formation of junctions in semiconductor substrates by means of a diffusion process is well known. The diffusion process may take various forms. In one case, diffusion may occur from a source material in vapor form, e.g. phosphine. Another process may employ the formation of a solid layer containing the dopant source, and heating the solid layer so as to cause the dopant to diffuse from that layer into the substrate. Still other processes employ so-called "spin-on" materials that are applied as a coating to the substrate, after which the coatings are fired so as to cause the diffusion process to occur.

U.S. Patent No. 4,451,969, issued June 5, 1984 to Arup R. Chaudhuri for "Method Of Fabricating Solar Cells", U.S. Patent No. 4,751,191, issued June 14, 1988 to Ronald C. Gonsiorawski et al for "Method Of Fabricating Solar Cells With Silicon Nitride Coating", and U.S. Patent No. 4,152,824, issued May 8, 1979 to Ronald Gonsiorawski for "Manufacture of Solar Cells", disclose various methods of making semiconductor solar cells wherein a p-n junction is formed by diffusion from a solid or gaseous source. Further information regarding diffusion processes for forming p-n junctions is provided by the references cited in the above-identified patents. Additional information regarding use of gaseous and liquid dopant sources is provided by K. S. Tarneja et al, "Investigation of Liquid Dopants for the Production of High Efficiency Solar Cells from Dendritic Web Silicon", J. Electrochemical Soc., Vol. 131, No. 10, pp. 2438-2441, Oct. 1984.

In the diffused junction manufacturing method described in U.S. Patents Nos. 4,451,969 and 4,751,191, the junction is formed by exposing the silicon substrate in a diffusion furnace to a continuous flow of a gaseous atmosphere comprising oxygen, nitrogen and a phosphorus source such as phosphine (PH₃) at a temperature of about 900°C for approximately 30 minutes. In the diffusion furnace, a number of reactions occur, but the important reaction is the formation of a phosphosilicate glass represented by the formula (P₂O₅)ₓ(SiO₂)_{y}. That glass is removed from the ribbon by etching it in a buffered HF acid solution for a period of about two minutes.

Gaseous diffusion processes as described in the above-identified prior art (which typify the diffusion processes used by various companies manufacturing solar cells) offer the disadvantages of relatively high cost and a hazardous toxic environment. Also the diffusion is not confined to just one surface of the substrates, thereby necessitating a subsequent junction isolation step, e.g., as described in U.S. Patent Application Ser. No. 375,037, filed June 30, 1989 by Ronald H. Micheels et al for "Solar Cell With Trench Through P-N Junction" (US-A-4 989 059).

It is also known from U.S. Patent No. 4,273,950 issued June 16, 1981 to Sanjiv R. Chitre for "Solar Cell and Fabrication Thereof Using Microwaves" that p-n junctions in semiconductor substrates of a first conductivity type may be formed by (i) spray coating at least one surface of the substrate with a liquid, second conductivity type dopant-containing material; (ii) drying the dopant-containing layer(s) in an oven so as to leave a dopant-containing residue ; and (iii) heating the coated substrate in a unipolar microwave field so as to cause the dopant material to diffuse into the substrate to form at least one region of a second conductivity type and at least one shallow p-n junction therein.

In addition, it is known from U.S. Patent No. 4,360,393 issued November 23, 1982 to Timothy D. Koval for "Vapor Disposition of H₃PO₄ And Formation Of Thin Phosphorus Layer On Silicon Substrates" (i) that the spraying of a dopant-containing liquid source material onto a semiconductor substrate may be accomplished by an atomizer (with or without an inert gas) at elevated temperature so that the spray comprises minute droplets, and (ii) that the spraying step and a subsequent substrate firing step may be accomplished sequentially in separate chambers.

The operation of ultrasonic spray nozzles is described in an article entitled "Ultrasonic Nozzles Atomize Without Air" by Harvey L. Berger in Machine Design, 21 July 1988.

Further, U.S. Patent No. 4,836,137 issued June 6, 1989 to Werner Heine and Helmut Kurz for "Apparatus For Electrostatically Spray Coating Workpieces With Air Ionizing Neutralizing Device" and a brochure of Integrated Technologies, Inc. entitled "Series PM2000 Modular Precision SPRAY COATING & DRYING Systems" (undated) describe the use of adjacent spray coating and drying chambers through which workpieces are transported by conveyor means.

Problems remain, however, regarding the uniformity and depth of the dopant diffusion and the etching quality of the glass-like residue which remains on the surface of the substrate after diffusion firing. Accordingly, in view of the desire to reduce manufacturing costs while improving reliability, efforts have been made to simplify and render more reliable and less costly the junction-forming operation.

### OBJECTS OF THE INVENTION

The primary object of the invention is to provide a new method and apparatus for forming p-n junctions by diffusion in silicon substrates.

Another primary object of this invention is to provide a new and improved method of forming photovoltaic junctions by diffusion in silicon substrates, whereby to produce silicon photovoltaic cells.

Still another primary object of this invention is to provide a method and apparatus for diffusing junctions into ribbon-like substrates so that the diffusion is essentially confined to one of the two opposite broad surfaces of the substrate, thereby avoiding the need of a junction isolation step.

A further object of the invention is to provide a novel method and apparatus for forming a p-n junction in a substrate that essentially involves (1) application of a dopant source material in a liquid or semi-liquid form to one surface of the substrate, and (2) heating of the substrate and the source material so as to cause the dopant to be released from the source material and to diffuse into the substrate so as to form a shallow and uniform p-n junction.

A more specific object of the invention is to provide a method of making solar cells using p-type silicon substrates, whereby an n⁺ type dopant is applied to the substrate in a liquid vehicle, and the liquid vehicle is thereafter fired so as to cause the dopant to diffuse into the substrate and form a shallow p-n junction.

Another more specific object of the invention is to provide a method of forming solar cells using EFG-type polycrystalline substrates wherein a liquid dopant source material containing a predetermined dopant is sprayed onto one side of the substrate as a thin and uniform coating, and thereafter the substrate and the liquid source material are fired so as to cause the dopant to be diffused into the substrate and thereby form a p-n junction.

Still another specific object of the invention is to provide novel apparatus for applying a liquid dopant source material to a substrate in preparation for formation of a junction by diffusion.

Another specific object of this invention is to provide a method of manufacturing solar cells involving the formation of photovoltaic junctions in pre-formed substrates by a diffusion doping process wherein a dopant source material is applied to one side of the substrates by a spray apparatus, and the substrates are supported on a liquid-absorbent conveyor web or belt during application of the dopant source material, so as to prevent dopant source material from coating the rear sides of the substrates.

The foregoing objects, plus other objects hereinafter described or rendered obvious, are achieved by a method and apparatus which may be generally characterized as follows: (1) a flat, ribbon-type silicon substrate is sprayed with a thin, uniform coating of a source material containing a selected dopant, (2) the coated substrate is then passed through a drying stage wherein the liquid source material is dried; and (3) thereafter the substrate is subjected to firing in a diffusion furnace in an oxygen-containing environment under conditions calculated to cause the dopant in the source material to diffuse into the substrate so as to form a shallow p-n junction. A liquid spray apparatus is used to apply the liquid source material as a fine spray-like mist. In the preferred embodiment of the invention, the substrates are transported on a liquid-absorbing conveyor past the spray apparatus, and the spray apparatus comprises an ultrasonic spray head mounted above the conveyor by means adapted to reciprocate the spray head transversely to the path of movement of the substrates on the conveyor, whereby to cause the liquid source material to be applied in a reciprocating spray pattern, with the reciprocating speed of the spray head and the linear motion speed of the conveyor being set so that each line of liquid discharged by the spray head will overlap a previously deposited line of liquid and thereby form a continuous coating on the substrate. That coating is subsequently fired so as to cause the diffusion process to occur. By appropriately selecting the source material and the operating conditions, it is possible to obtain a relatively uniform shallow junction in p-type silicon material where the junction has a depth of approximately 0.5 micrometers.

More particularly, the method of the invention is a method of forming p-n junctions in silicon substrates to provide silicon photovoltaic cells, comprising the steps of:
(a) delivering a plurality of silicon substrates, each having a front surface and a back surface, into a first processing chamber, the substrates being of a first conductivity type ;
(b) spray coating each of the front surfaces in the first processing chamber with a liquid dopant-containing material by means of an ultrasonic spray device so as to form on each of the front surfaces a layer of the dopant-containing material having a thickness substantially less than that of the substrates, the dopant being of a second, opposite conductivity type ;
(c) removing the substrates from the first processing chamber and delivering the substrates to a second processing chamber ;
(d) drying the layers in the second processing chamber so as to leave a dopant-containing residue on each of the front surfaces ;
(e) removing the substrates from the second processing chamber and delivering the substrates to a firing chamber ; and
(f) firing the substrates in the firing chamber in an oxygen-containing environment so as to cause diffusion of the dopant from the residues into the substrates so as to provide in each of the substrates a region of the second, opposite conductivity type, and a p-n junction adjacent the front surface ;
the method being characterized by maintaining the relative humidity of an air atmosphere in the first processing chamber within a preselected range.

Other features of the method according to the present invention are disclosed in sub-claims 2 to 13.

Further, the apparatus of the invention is an apparatus for forming shallow p-n junctions in silicon substrates to produce silicon photovoltaic cells, each substrate being of a first conductivity type and having a front surface and a back surface, the apparatus comprising :
(a) a first processing chamber ;
(b) a second processing chamber adjacent the first processing chamber ;
(c) conveyor means for supporting the substrates on the back surfaces thereof and for sequentially moving same into, through and out of the first processing chamber and the second processing chamber ;
(d) an ultrasonic spray device at least partially disposed in the first processing chamber, the spray device being adapted to spray coat the front surfaces of each of the substrates with a continuous, substantially uniform layer of a liquid source material having as a constituent a dopant of a second, opposite conductivity type as the substrates move on the conveyor means through the first processing chamber ;
(e) means for maintaining the second processing chamber at a preselected temperature so as to dry the layers as the substrates move on the conveyor means through the second processing chamber ;
(f) a firing chamber ;
(g) means for conveying the substrates carrying the dried layers from the conveyor means into, through and out of the firing chamber ; and
(h) firing means in the firing chamber for heating the substrates carrying the dried layers as they move through the firing chamber at a temperature and for a time sufficient to cause diffusion of the dopant constituent of the dried layers into the front surfaces of the substrates and to form p-n junctions at substantially uniform depths relative to the front surfaces of each of the substrates ;
the apparatus being characterized in that :
(i) air conduit means communicates with the first processing chamber for admitting moisturized air thereinto ; and
(ii) first humidity sensor means is disposed in the first processing chamber for providing signals to a control means for control of the flow of moisturizing air through the air conduit means proximate the spray device so as to maintain the relative humidity in the first processing chamber proximate the spray device in a selected range.

Sub-claims 15 to 22 disclose important features of this apparatus.

Other advantages and features of the invention are described or rendered obvious by the following detailed specification of the invention which is to be considered together with the accompanying drawings.

### THE DRAWINGS

Figs. 1A-1E illustrate some of the steps involved in making solar cell p-n junctions according to this invention;
Fig. 2 is a schematic view in side elevation illustrating the apparatus and method for forming diffused junctions and solar cells according to this invention;
Fig. 3 is an enlarged schematic cross-sectional view in front elevation of the spray head used in practicing the present invention; and
Fig. 4 is an enlarged schematic view illustrating how the ultrasonic spray head is mounted for reciprocation above the substrates.

In the drawings, for convenience of description and illustration, the thicknesses and depths of the substrates and the several coatings and doped regions, and the mechanical parts are not shown exactly in accordance with their true relative positions and proportions.

### DETAILED DESCRIPTION OF THE INVENTION

This invention is directed to providing a high performance junction formation technique calculated to reduce the cost of producing relatively high efficiency, reliable silicon photovoltaic cells and related devices.

Prior to this invention, it has been known that dopant diffusion in a semiconductor device may be accomplished by applying a liquid source material to a substrate in various ways, e.g, by spin-on and spraying techniques. However, in relation to the manufacture of solar cells, the concept of spraying a diffusion source onto a silicon substrate is subject to a number of significant considerations, including the need to have a shallow as well as a uniform junction, and also the need to avoid the formation of a junction on the rear side of the solar cell.

The present invention is particularly, but not necessarily, adapted for a cell-processing method wherein p-type silicon EFG substrates are processed to form shallow p-n junctions. The formation of the p-n junction involves the introduction of a dopant such as phosphorus so as to produce an n⁺ region at one side of the substrates.

While the idea of spraying a liquid dopant diffusion source onto a semiconductor substrate is well known, heretofore it has not been known how to utilize that approach so as to produce in each of a series of pre-formed silicon substrates a shallow and uniform photovoltaic junction, and to do so using mass production methods so as to obtain relatively high efficiency solar cells at reduced cost. In particular, one area of concern in relation to the diffusion junction-formation problem has been the desire, for reasons of costs and the like, to avoid the formation of a junction on the rear side of the solar cell. The creation of a junction on the rear side of the solar cell is undesirable since it necessitates a junction isolation step in the overall manufacturing process. U.S. Patent Application Ser. No. 375,037, supra, discloses the concept of using a laser to accomplish junction isolation in the case where the front side diffusion is accompanied by diffusion on the rear side of the substrate.

The present invention requires that a (1) liquid or semi-liquid dopant source be applied onto a series of substrates as a thin, uniform coating, and (2) that coating be heat-treated so as to cause formation of uniform and shallow p-n junctions in the substrates. In the preferred mode of practicing this invention, the liquid dopant is applied by mechanically manipulated ultrasonic means designed to assure that the dopant liquid is applied in a uniform layer, whereby to assure the formation of a p-n junction having a uniform depth and quality with a low dopant consumption.

Applicants preferably make use of an unpressurized atomizing process generally similar to the kind described by Harvey L. Berger, "Ultrasonic Nozzles Atomize Without Air", Machine Design, July 21, 1988. However, the spraying technique described in said publication is not related to the formation of solar cells in accordance with this invention.

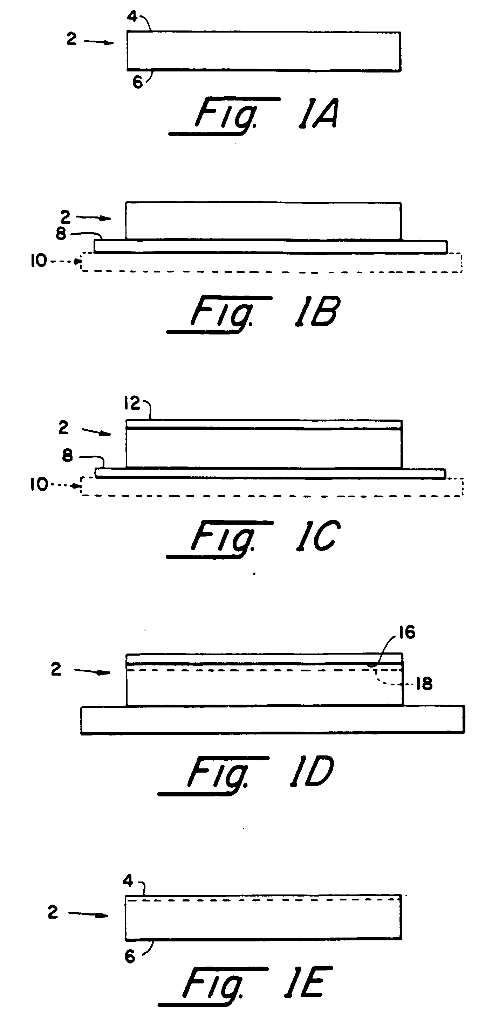

Referring now to Figs. 1A-1E, according to the preferred embodiment of the invention, silicon wafers or substrates in the form of flat ribbons 2 are processed to form photovoltaic solar cells. Each substrate 2 has broad oppositely disposed front and back surfaces 4 and 6. Each substrate 2 is p-type silicon material, preferably constituting a substrate grown by the EFG process and doped with boron to a conductivity in the range of 2-3 ohm-cm.

Each substrate 2 is disposed on a liquid-absorbent belt or web 8 which may itself act as a conveyor or which may be supported on or form part of a separate conveyor belt as shown in phantom at 10. Preferably belt 8 is made of paper or cloth, or a plastic-backed paper or cloth web, e.g., a polyethylene-coated paper web, and used without a separate conveyor belt 10 for reasons of economy and quality control. A plurality of substrates 2 are disposed in series on web 8, with the web having a width which is greater than the corresponding width of the substrates 2, as shown in Fig. 1B. It is preferred that belt 8 have a width great enough to accommodate several, e.g., 1-5, substrates disposed side by side. However, for simplicity of illustration and description, the invention is described on the assumption that a single row of substrates is disposed on web 8. The several substrates disposed in series on the web 8 are passed beneath a spray head mechanism which functions to apply a thin coating 12 (Fig. 1C) of a liquid dopant source to the upper side 4 of the substrate 2. The liquid dopant source material is applied in a uniform and very thin layer, and then dried.

Thereafter, the substrates are transferred, e.g., via another conveyor 14 (Fig. 1D), to one or more additional process stages where they are subjected to an organics-burnoff and also a firing step, so as to cause the formation of an n⁺ region 16 extending down from the upper surface of the substrate a distance of about 0.5 micrometer, so as to form a p-n junction 18. The firing causes a residual silicate glass-like layer 20 to be formed on the upper surface of the substrate. That glass-like layer is removed by a conventional HF etching treatment, thereby leaving the substrate with a relatively clean upper surface 4 (Fig. 1E). Also the rear or lower surface 6 has no significant n⁺ region formed therein.

In the above-described process, the liquid coating 12 is applied so as to cover substantially the entire top surface 4 of the substrate, with the spray head mechanism being designed and operated so that little dopant source material is sprayed directly on web 8, but in any event little or no liquid dopant source material reaches the rear side 6 of the substrate by a diffusion or wicking action, due to the absorbent nature of web 8.

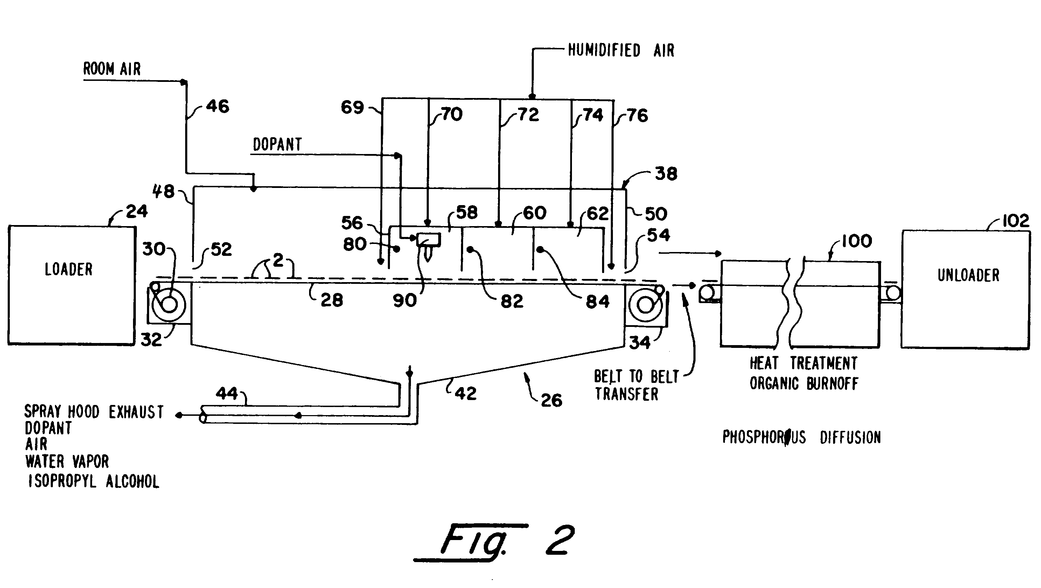

Referring now to Fig. 2, the invention is preferably practiced by apparatus that comprises a loader mechanism or stage 24 that is adapted to load a plurality of substrates 2, e.g., p-type silicon substrates, onto the conveyor of a selected liquid spray apparatus identified generally at 26. The latter comprises support means 28 for supporting a conveyor belt in the form of a paper web 30 that is fed by a web-feeding spool 32 and is taken up by a web-winding or take-up mechanism 34. Web 30 has a speed in the range of 12.7-254 cm (5-100 inches) per minute, preferably about 25.4-127 cm (10-50 inches) per minute.

Spray apparatus 26 also comprises a hood 38 that envelops the web 30 and silicon substrates 2 carried by that web, as well as other means hereinafter described. Hood 38 has a bottom manifold 42 with a discharge port 44 that is connected to a source of suction (not shown) so as to effect removal of air, undeposited dopant material, water vapor and the evaporated organic solvent constituents of the liquid dopant source material that is sprayed onto the substrates. The front and rear walls 48 and 50 of hood 38 have openings or windows 52 and 54 through which the conveyor belt 30 and the substrates carried thereby may pass into and out of the hood. Hood 38 comprises wall means 56 that define a spray chamber 58, a drying chamber 60, and a drying tunnel 62. Room air, i.e., air at room temperature and humidity, is fed into the front end of hood 38 via a line 46. The region in hood 38 immediately upstream of spray chamber 58, drying chamber 60, drying tunnel 62 and the region in hood 38 immediately downstream of drying tunnel 62 are supplied with humidified air at a temperature preferably in the range of 18.3-29.4 degrees C (65-85 degrees F), i.e., air with controlled humidity, via lines 69, 70, 72, 74 and 76 respectively. In accordance with this invention, the humidity to which the substrates are subjected in chambers 58 and 60 and drying tunnel 62 is controlled, with such control being effected by use of humidity sensors represented schematically at 80, 82 and 84 that are positioned to sense the relative humidity in chambers 58 and 60 and drying tunnel 62 and provide control signals to control means (not shown) that control the flow of humidified air in lines 70, 72 and 74. The relative humidity of the air in chambers 58 and 60 is kept in the range of 25 to 45 %, while the relative humidity in tunnel 62 is kept in the range of 25 to 60 %. Controlling humidity of the air in chambers 58 and 60 and tunnel 62 is critical in controlling the polymerization of the preferred dopant source which is hereinafter described. In this connection it is known that when the preferred dopant source is exposed to moisture in the air fed to chambers 58 and 60 and tunnel 62, further polymerization occurs. The rate of flow of humidified air in lines 69 and 76 is slightly greater than the rate of flow of humidified air in lines 70, 72 and 74, so as to cause the pressure in the region fed by lines 69 and 76 to exceed the pressure in chambers 58 and 60 and tunnel 62 only slightly, e.g., by less than 25.38 kg/m² (1 inch of water), thereby helping to prevent non-humidified air, i.e., room air, from flowing into chambers 58 and 60 and tunnel 62, without disturbing the uniformity of the spray described below.

Located in spray chamber 58 is an ultrasonic spray head 90 that is adapted to be reciprocated transversely of the longitudinal axis of the belt. In the spray chamber, a liquid spray dopant source is sprayed onto the substrates at room or near-room temperature, i.e., 18.3-29.4°C (65-85 degrees F), at a rate and with a dispensing pattern calculated to cause a uniform coating 12 (Fig. 1C) of the dopant source to be deposited onto the front surface of the substrates, with a minimum of overlap of the spray stream onto web 8. In the drying chamber 60 and drying tunnel 62 the liquid spray diffusion source material is dried at a temperature that is preferably in the range of 18.3-29.4 degrees C (65-85 degrees F), following which the substrates are conveyed out of spray apparatus 26 for subsequent organic burnoff and diffusion treatments which preferably are conducted in separate areas of an elongate infra-red furnace 100 of the type having a belt conveyor for transporting the substrates through the furnace chamber(s). In the organic burnoff heat treatment stage of furnace 100, the substrates are heated in air to a temperature that is preferably in the range of 300-500 degrees C so as to cause complete removal of residual organic constituents of the dopant source liquid by evaporation and combustion. In the diffusion stage of furnace 100, the substrates are fired in an air or oxygen atmosphere to a temperature in the range of 880 to 950 degrees C, whereby phosphorus in the dopant source material is caused to diffuse into the substrates and to form the n+ region 16 and junction 18 illustrated in Figs. 1A-1E. Use of the infra-red furnace offers the advantage of reducing the diffusion firing time for the desired junction depth. The substrates are removed from furnace 100 by a suitable unloading mechanism 102, after which the substrates are subjected to etching as described above to remove any glass-like silicate (or phosphosilicate) residue remaining on front surfaces 4 of the substrates.

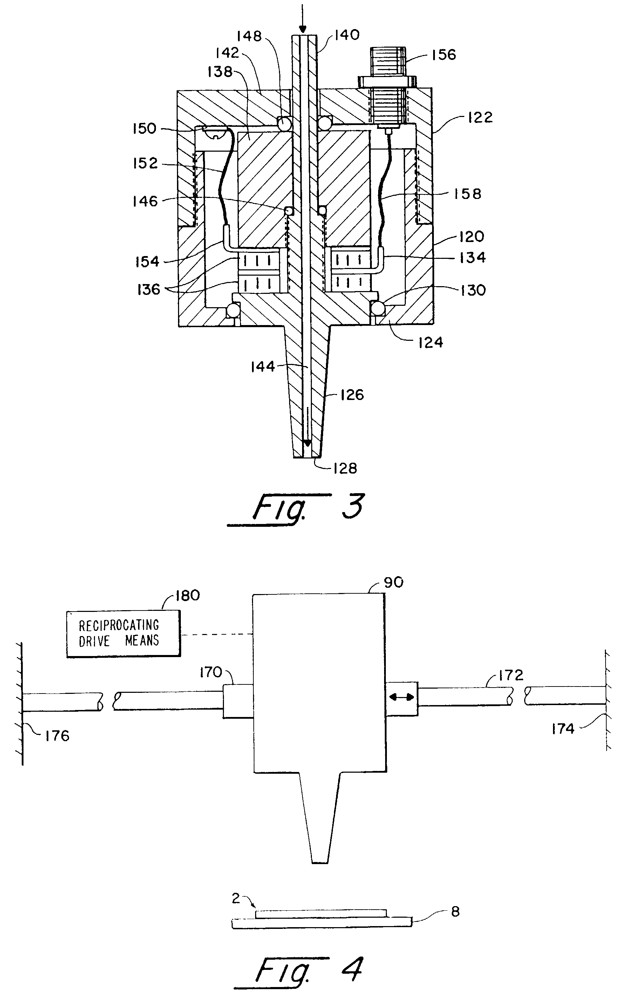

Fig. 3 illustrates a preferred form of ultrasonic spray head used in the practice of the invention. Ultrasonic spray heads are well known, as exemplified by U.S. Patents Nos. 4,723,708, 4,153,201, 4,337,896, and 4,301,968 and the Berger article, supra. More specifically, the device illustrated in Fig. 3 comprises a shroud or housing in the form of a front shroud or housing member 120 and a rear shroud or housing member 122 which are screwed together. Front shroud 120 has an end wall 124 in which is disposed a hollow conically-shaped atomizing horn or nozzle 126 with a "micro-spray" tip 128 as illustrated and described in the Berger article, supra. An O-ring 130 is disposed between end wall 124 and horn 126. The spray head comprises an ultrasonic driver in the form of an annular metal electrode 134 disposed between a pair of annular piezoelectric disks 136. The latter are mounted in coaxial but radially-shaped relation with a threaded central tubular extension 138 of atomizing horn 126 that is screwed into a rear horn or dummy section 140. Extension 138 extends through rear horn section 140 and also through the rear wall 142 of the rear shroud 122. Horn 126 and extension 138 have a common central bore 144 that functions as a feed passageway for the liquid dopant source. O-rings 146 and 148 are disposed between the front and rear horn sections 126 and 140 and between rear end wall 142 and the rear horn section.

The rear shroud has a ground terminal 150 which is connected by a suitable wire lead 152 to a ground electrode 154 located on one side of the piezoelectric assembly. Additionally an electrical connector 156 is mounted in the rear wall 142 and is coupled by a conductive wire 158 to the front electrode 134.

The device illustrated in Fig. 3 is designed to provide a transverse mode of vibration, i.e., the energization of the piezoelectric crystals causes the front and rear horns to vibrate transversely to the longitudinal axis of the device. The rear end of extension 138 is connected via a hose or other conduit (not shown) to a supply of liquid dopant source material (also not shown). The liquid dopant source material is fed to the spray head under atmospheric or near-atmospheric pressure by gravity or a suitable low-pressure positive displacement-type metering pump (not shown) that preferably requires no air to deliver the liquid dopant material. If a pump is used, its output pressure preferably should not exceed about 35.04-43.8 g/cm² (16-20 psi). Preferably, but not necessarily, an ultrasonic spray head of the type manufactured by Sono-Tek of Poughkeepsie, New York is used. In this connection, it should be noted that the spray head shown in Fig. 3 is generally the same as the devices shown in U.S. Patent No. 4,723,708 and the aforesaid article by Berger. By way of example but not limitation, the ultrasonic spray head may be a Sono-Tek Model 8700-120 spray head that operates at a frequency of about 48 kHz, while a Model 909 syringe-type pump made by Harvard Apparatus Corp. of South Natick, Massachusetts, may be used to supply dopant source material to the spray head. The central bore 144 in the nozzle preferably has a diameter at its discharge end in the range of about .038 cm (0.015 inch) to about .076 cm (0.030 inch), preferably about .051 cm (0.020 inch), whereby ultra-fine micrometer-size drops are discharged in a "soft" low velocity spray or fog.

Referring now to Fig. 4, ultrasonic spray head 90 is mounted for reciprocation transversely of the longitudinal axis and path of movement of the paper web. By way of example, but not limitation, the ultrasonic spray head is mounted to a carriage 170 that is mounted for reciprocation on one or more slide rods 172 that are anchored to suitable fixed supports 174, 176 and extend horizontally over the belt. A suitable drive means represented schematically at 180 is used to reciprocate the ultrasonic nozzle at a selected rate, preferably about 48 complete strokes (back and forth) per minute.

Various liquid dopant source materials may be used in the practice of this invention. By way of example but not limitation, the liquid dopant source may comprise a phosphorus spin-on dopant such as one of the . spin-on dopants sold by Allied-Signal Inc., Milpitas, CA, under the designations P-8, P-8540 and P-8545. These particular spin-on materials comprise a phosphosilicate polymer in an alcohol/ester solution. The phosphosilicate polymer is represented by the following formula:

[SiOₐ(OC₂H₅)_{b}(OH)_{c}(OP)_{d}]ₙ,

where a ≥ 1, b and c ≤ 0.5, d ≤ 1.0, and n= 5-100, with the molecular weight of the polymer being in the range of 500 to 10,000. The alcohol ester solution comprises a mixture of ethanol, isopropyl alcohol, n-propyl alcohol, and ethyl acetate. The P-8545 material is preferred. That material is believed to comprise by weight approximately 4.9% phosphosilicate polymer, 2% ethanol, 36% isopropyl alcohol, 12% ethyl acetate, and 45% propyl alcohol. For this invention, it is preferred that said material be diluted so as to provide a dopant-to-solvent ratio by volume that facilitates the proper spray diffusion pattern and assures formation of a uniform layer of dopant source material on the substrates. By way of example, the P-8545 material is diluted by increasing the concentrations of ethanol, isopropyl alcohol, n-propyl alcohol and ethyl acetate by about 50% by volume. When the phosphosilicate polymer is deposited and dried in chambers 58 and 60 and tunnel 62, further polymerization occurs, with the extent of polymerization being dependent in part on the humidity and air flow in those chambers and tunnel.

The use of a paper web or belt is required for the purpose of substantially preventing any of the sprayed liquid source material from migrating onto the rear side of the substrates disposed on the belt. The ultrasonic spray head 90 is reciprocated by drive means 180 so that its nozzle passes slightly beyond the opposite edges of the substrates as it reaches first one end and then the other end of its operating stroke. Preferably movement of the ultrasonic spray head is such that it extends beyond each opposite edge of the substrates by about 1.27 to 2.54 cm (0.5 to 1.0 inch), thereby avoiding any undesired concentration of dopant material where the spray head reverses its direction of movement relative to web 30.

Notwithstanding the absorption of excess dopant liquid by paper web 8, it has been determined that a relatively small amount of the source material may bleed via web 8 over to the rear surfaces of the substrates by a distance not exceeding about .076 cm (0.030 inch) inwardly of one or both side edges of the substrates, generally not more than to about .025 cm (0.010 inch) to about .038 cm (0.015 inch). However, the pickup of dopant source material is subject to a gradient phenomenon, so that the concentration of phosphorus picked up by the rear surface of the substrate decreases sharply with increasing distance from the side edge of the substrate. Accordingly, the concentration of phosphorus that will diffuse into the rear sides of the substrates during the diffusion heat treatment will be quite low, so that at worst only a very high resistance and negligible short-circuit can result. Therefore, no junction isolation treatment is required.

In this connection, it is to be appreciated that the manufacture of silicon solar cells typically involves the application of a thin layer of aluminum on the rear side of the substrates, with the aluminum functioning as the rear contact for the solar cells. Preferably, but not necessarily, the application of the aluminum layer on the rear side of the substrate is controlled so that the aluminum layer terminates about .127 cm (0.050 inches) from the edges of the substrate, thereby further minimizing the effect of any overlap and absorption of liquid source material on the rear side of the substrates and thereby further avoiding the need for any subsequent junction isolation procedure.

As noted above, the paper web or belt 8 limits weeping of the source material onto the rear side of the substrates. Accordingly, it is to be appreciated that paper web 8 may be made of another material, e.g., a web made of a cloth material such as cotton, which is capable of absorbing but is also resistant to the source material. An aspect of the invention is that the paper web 8 or 30 is not subjected to high temperatures, thereby avoiding possible deterioration or combustion of that web or belt.

In drying chamber 60 and drying tunnel 62 the major fraction of the volatile organic components of the liquid source material are evaporated. Any residual organic material on the substrates is burned off and thus removed from the system in the subsequent organic burn-off treatment which (as noted above) may or may not be incorporated in the same appparatus in which the phosphorus diffusion is accomplished. Preferably, the heat treatment that removes residual organic material is conducted at a temperature of about 300 to 500 degrees C for a period of about 3.0 minutes, and that treatment may be accomplished in a continuous furnace having a first stage for the aforesaid heat treatment, plus at least a second stage for the phosphorus diffusion. In the second stage, i.e., in the phosphorus diffusion firing stage, the substrates are fired at a temperature in the range of about 880 to about 950 degrees C, preferably a temperature of about 890 degrees C, for about 5-20 minutes.

The ultrasonic spray head is designed to apply the dopant source material at a rate in the range of 0.3 to 5.0 ml/per minute, so that under the preferred operating conditions, the liquid source material is applied in a thickness in the range of about 100 to 200 nm. After the foregoing coatings have been dried and fired, they will have a thickness of approximately 100 nm or less.

Following is an example of how to practice the invention using apparatus as shown in Figs. 2-4.

### EXAMPLE

P-type silicon substrates, preferably constituting substrates produced by the EFG crystal growth method, are loaded one at a time onto the paper web conveyor 30 by the loader mechanism 24. The substrates are flat rectangular wafers measuring approximately 10.16 by 10.16 cm (4 by 4 inches), and have a thickness of approximately .038 cm (0.015 inch). The substrates also have a resistivity in the range of 2-3 ohm-cm. The paper web 30 is operated at a speed of approximately 25.4 cm (10 inches) per minute. Air at room temperature and humidity conditions, i.e., 25 degrees C and 30% relative humidity, is injected into the apparatus via line 46 at a rate of approximately 22,656 L per minute (800 SCFM). Humidified air is injected into chambers 58, 60 and drying tunnel 62, as well as into the area immediately preceding chamber 58 and the area immediately following chamber 62, via lines 69, 70, 72 and 74 and 76. The humidified air has a relative humidity of 25-60% and a temperature in the range of 18.3-29.4 degrees (65-85 degrees F). That humidified air is injected into lines 69, 70, 72, 74 and 76 at respective rates of 2.83-2,832 L per hour (0.1-100 SCFH), 2.83-283.2 L per hour (0.1-10 SCFH), 2.83-283 L per hour (0.1-10 SCFH), 2.83-283.2 L per hour (0.1-10 SCFH), and 2.83-2,832 L per hour (0.1-100 SCFH), with the air being fed into lines 69 and 76 at a higher rate than it is fed into lines 70, 72 and 74, so as to minimize infiltration of room air into chambers 58 and 60 and tunnel 62. No heat is supplied to the hood 38, and whatever materials are evaporated are removed from the hood via the line 44.

A liquid dopant material in the form of Allied-Signal material P-8545, diluted by increasing the concentrations of ethanol, isopropyl alcohol, n-propyl alcohol and ethyl acetate by 50% by volume is dispensed by spray nozzle 90 at a rate in the range of 0.3 to 0.5 ml/per minute, with the ultrasonic spray head being operated at a frequency of 48 kHz. The discharge orifice of the spray nozzle measures about .051 cm (0.020 inch) in diameter, and the spray head is reciprocated back and forth at a rate of 48 complete (back and forth) strokes per minute, with the tip of the nozzle surface 128 being spaced approximately .318 to .635 cm (1/8 to 1/4 inch) from the upper surface of the substrates disposed on web 30.

As a result of the foregoing conditions, a uniform continuous coating of the liquid dopant source material is applied to the substrates in a thickness ranging between about 0.1 and 0.2 micrometers. The spray from the nozzle has a narrow dispersion pattern not exceeding about .318 cm (1/8 inch) wide that tends to spread on the wafer to a width of about .635-1.27 cm (1/4-1/2 inch), and that pattern combined with the selected conveyor speed assures that each "line" of liquid sprayed onto each substrate overlaps or otherwise melds with each preceding and succeeding line of liquid. The wafers passing out of chamber 58 are subjected to a preliminary drying operation in chamber 60 and then to a further drying operation in tunnel 62.

The humidity sensors 80, 82 and 84 sense the humidity in the chambers 58, 60 and 62 and cause a control mechanism (not shown) to adjust the rates of flow of humidified air into the lines 70, 72, 74 and 76 so that the humidity is maintained as follows: in chamber 58, 25-45% RH; in chamber 60, 25-45% RH; and in chamber 62, 25-60% RH.

The wafers pass out of the spray hood apparatus into a heat treatment and diffusion furnace 100. They travel through the furnace at a rate of about 25.4 cm (10 inches)/minute. The furnace comprises a first organics burn-off stage and a second phosphorus diffusion stage. In the first organic burn-off stage, the substrates are subjected to an air or oxygen environment at a temperature in the range of 300-450 degrees C for a period of approximately 3 minutes, whereby complete removal of the residual organic constituents of the dopant source liquid is achieved by further evaporation and combustion. The furnace is operated so that the temperature in its diffusion stage is about 890 degrees C, with an air or oxygen atmosphere being present in that stage. The duration of the substrates in the diffusion stage at the temperature of about 890 degrees C is approximately 10 minutes, whereby phosphorus from the liquid dopant source layer is caused to diffuse into the substrates and to form the n⁺ region 16 and the junction 18 as mentioned previously, with the junction being about 0.5 micrometer below surface 4.

The substrates are removed from the furnace by unloader 102 and are passed to an etching stage where they are subjected to a buffered hydrogen fluoride (HF/NH₄) etching bath long enough to remove glass-like silicate (or phosphosilicate) residue remaining on the front surfaces 4 of the substrates.

Substrates treated according to the foregoing example offer the advantage that a relatively uniform n⁺ region 16 is formed, so that the junction 18 has an essentially uniform depth across the substrates. The substrates resulting from the process offer the advantage that there is little or no phosphorus diffusion evident on the rear sides of the substrates. Whatever phosphorus diffusion occurs is subject to a sharply decreasing gradient, so that little or no phosphorus dopant presence is evidenced on the rear surfaces at a distance of approximately .076 (0.030 inch) inboard of the side edges of the substrates. Hence there is no need to subject the substrates to a junction isolation procedure.

Following the etching procedure, the substrates are subjected to an aluminumization treatment so as to cause the formation of an aluminum electrode on the rear side of the substrates. The aluminum electrodes are formed so that they are spaced a distance approximately .127 cm (0.050 inches) inboard of the side edges of the substrates, thereby further avoiding any need for junction isolation treatment since there is virtually no short-circuiting of the junction. The aluminum electrodes may be formed in various ways known to the art, e.g., as described in U.S. Patents Nos. 4,451,969 and 4,751,191, except that (as noted above) it is preferred that the aluminum electrodes be spaced from the side edges of the substrate.

It is to be appreciated that it may be possible for some solar cell manufacturing processes to use an air brush-type spray head, or possibly some other type of spray head in place of the ultrasonic spray head herein described and illustrated. However, an ultrasonic spray head is preferred since it offers the advantage of providing a relatively "soft" unpressurized spray, whereby the spray may be confined to a very narrow area. In this connection it is to be noted that if the nozzle opening 144 has a diameter not exceeding about .076 cm (0.030 inch), preferably about .051 cm (0.020 inch), the spray which is discharged by the ultrasonic head, not only is a low velocity "soft spray", but in addition it has a relatively narrow and uniform dispersion pattern and offers the advantage that it is not air-borne.

The foregoing invention offers a number of advantages. First of all, the low velocity of the dopant source stream ejected by the ultrasonic nozzle tends to avoid any physical disturbance of the blanks on the paper web 8 (or 30). An air brush has been used in place of the ultrasonic nozzle for the purpose of spraying liquid dopant source material on the substrates, but it was found that the relatively higher velocity of the air stream injected by the air brush may cause movement of the substrates on the web, which in turn tends to result in an increase in the amount of liquid dopant source deposited on the back side of the substrate. It is appreciated that an air brush may be suitable for applying liquid dopant source material in the case where the substrates are relatively flat, e.g., Czochralski substrates, but it is preferred to use an ultrasonic spray head where the substrates are EFG material, since EFG substrates tend to have an irregular surface, and that irregular surface tends to increase the likelihood of disturbance of the substrates on the web by air currents, thus increasing the possibility of migration of source material onto the rear sides of the substrates.

It is to be noted that the degree of polymerization of the preferred dopant material is a function of the humidity to which the liquid dopant source material is exposed in the spray apparatus, and the degree of polymerization in turn affects the etching quality of the glass-like residue remaining on the substrates after the diffusion firing procedure, as well as the uniformity and depth of the phosphorus diffusion.

Obviously other liquid dopant sources known to persons skilled in the art may be used in the practice of this invention, e.g., water-based phosphorus dopant sources. It is to be appreciated also that other process conditions may be varied. Thus, for example, the web speed may be changed, the spray head may be operated at a different frequency, the rate of reciprocation of the spray head may be changed, and the rate of feeding of the liquid dopant source and the thickness of the layer of that source deposited on the substrates by the spray head also may be varied.

It also is contemplated that more than one reciprocating spray head may be used, and also that the single reciprocating spray head shown in the drawings could be replaced by a plurality of fixed spray heads arranged so as to apply a uniform coating of the liquid source material over the full expanse of the top surfaces of the substrates on the web.

A key advantage of the invention is that it reduces costs by an economical minimum use of dopant source material which is relatively expensive. Furthermore, use of a low velocity, relative low flow rate spray apparatus for dispensing the liquid dopant material onto the substrates leads to a reduction in the amount of wraparound that occurs, i.e., less dopant is absorbed by the rear surface of the substrates.

## Claims

1. A method of forming p-n junctions in silicon substrates to provide silicon photovoltaic cells, comprising the steps of :
(a) delivering a plurality of silicon substrates (2), each having a front surface (4) and a back surface (6), into a first processing chamber (58), said substrates (2) being of a first conductivity type;
(b) spray coating each of said front surfaces (4) in said first processing chamber (58) with a liquid dopant-containing material by means of an ultrasonic spray device (90) so as to form on each of said front surfaces (4) a layer (12) of said liquid dopant-containing material having a thickness substantially less than that of the substrates (2), said dopant being of a second, opposite conductivity type;
(c) removing said substrates (2) from said first processing chamber (58) and delivering said substrates (2) to a second processing chamber (60);
(d) drying said layers (12) in said second processing chamber (60) so as to leave a dopant-containing residue on each of said front surfaces (4);
(e) removing said substrates (2) from said second processing chamber (60) and delivering said substrates to a firing chamber (100); and
(f) firing said substrates (2) in said firing chamber (100) in an oxygen-containing environment so as to cause diffusion of said dopant from said residues into said substrates (2) so as to provide in each of said substrates (2) a region of said second, opposite conductivity type, and a p-n junction (18) adjacent said front surface (4);
said method characterized by maintaining the relative humidity of an air atmosphere in said first processing chamber within a preselected range.

2. The method according to claim 1 wherein step (f) is carried out at a firing temperature of 890 degrees C.

3. The method according to claim 1 wherein said substrates (2) are transported through said first processing chamber (58) along a straight line path and said ultrasonic spray device (90) is reciprocated across said substrates (2) transversely to the direction in which said substrates (2) are transported at a rate on the order of about 48 complete strokes per minute.

4. The method according to claim 1 wherein each said layer (12) is formed with a thickness of between about 0.1 micrometer and about 0.2 micrometer.

5. The method according to claim 1 wherein said dopant is phosphorus.

6. The method according to claim 1 wherein:
(a) said substrates (2) are of boron-doped silicon,
(b) said liquid dopant-containing material (1) comprises phosphorus, (2) is applied to said substrates at a temperature of 18.3-29.4 degrees C in the presence of air having a relative humidity of 25-45%, and (3) is dried at a temperature of between 18.3 and 29.4 degrees C for between 2 and 5 minutes in the presence of air having a relative humidity of 25-60%, and
(c) said substrates (2) are fired at a temperature of about 890 degrees C for a time sufficient to form a shallow p-n junction (18) by diffusion of said dopant.

7. The method according to claim 6 wherein said dopant is phosphorus and is diffused into said front surfaces (4) of said substrates (2) to a depth of about 0.5 micrometers.

8. The method according to claim 6 wherein each of said layers (12) of liquid dopant-containing material has a thickness between about 100 and about 200 nanometers.

9. The method according to claim 1 wherein said ultrasonic device (90) includes a nozzle (126) having a distal end adapted to emit a substantially conical spray pattern of substantially micrometer-sized droplets, said conical spray pattern having a maximum diameter of .318 cm at a distance of .635 cm from said distal end of said nozzle (126), said ultrasonic spray device (90) being operated at a frequency on the order of 48 kHz, said substrates (2) being transported at a rate of between 12.7 and 254 cm per minute relative to said nozzle (126) in a first substantially horizontal plane such that said front surfaces (4) of said substrates (2) are located between 3.18 and .635 cm below said distal end of said nozzle (126), and said distal end of said nozzle (126) is reciprocated across said substrates (2) transversely to the direction of transport of said substrates (2) in a second substantially horizontal plane at a rate of about 48 complete cycles per minute.

10. The method according to claim 1, characterized in that :
- said silicon substrates (2) are flat silicon substrates,
- the delivering step (a) is carried out by placing said plurality of flat silicon substrates (2) onto a conveyor (30) and transporting said substrates (2) via said conveyor (30) into said first processing chamber (58),
- said ultrasonic spray device (90) is reciprocated transversely across said substrates (2) at a rate of 48 cycles per minute in a plane parallel to the plane containing said substrates (2) in said first processing chamber (58),
- the liquid layer (12) is applied to a thickness between 100 and 200 nanometers,
- said drying step (d) is carried out at a temperature between 18.3 and 29.4° C in an air atmosphere having a relative humidity maintained between 25 % and 45 %,
- in said delivering step (e), said substrates (2) are delivered to an infra-red furnace (100) on a second conveyor (14) adapted to withstand high temperatures,
- in said step (f), said firing is carried out at a temperature and for a period of time sufficient to cause said dopant to diffuse into said substrates (2) to a depth of 0.5 micrometer, and
- in step (a), an air atmosphere is maintained in said first processing chamber (58) with a relative humidity of 25 % to 45 % and in step (b), the spray coating of said substrates in said first processing chamber is carried out by maintaining said relative humidity in said first chamber in said range.

11. The method according to claim 10 wherein said substrates (2) are doped with boron, said liquid source material comprises phosphorus, and in step (f) said substrates (2) are fired to a temperature of 880-950 degrees C.

12. The method according to claim 10 wherein in step (b) said liquid dopant-containing material comprises a phosphosilicate polymer.

13. The method according to claim 1, wherein the delivering step (a) is carried out by placing said plurality of silicon substrates (2) onto a conveyor (30) and transporting said substrates (2) via said conveyor (30) into said first processing chamber (58), said conveyor (30) being provided with liquid absorbing surface portions and each of said substrates (2) being placed such that said back surface (6) is in contact with one of said liquid-absorbing surface portions of said conveyor (30).

14. An apparatus for forming shallow p-n junctions in silicon substrates (2) to produce silicon photovoltaic cells, each said substrate (2) being of a first conductivity type and having a front surface (4) and back surface (6), said apparatus comprising :
(a) a first processing chamber (58) ;
(b) a second processing chamber (60) adjacent said first processing chamber (58) ;
(c) conveyor means (30) for supporting said substrates (2) on the back surfaces (6) thereof and for sequentially moving same into, through and out of said first processing chamber (58) and said second processing chamber (60) ;
(d) an ultrasonic spray device (90) at least partially disposed in said first processing chamber (58), said spray device (90) being adapted to spray coat the front surfaces (4) of each of said substrates (2) with a continous, substantially uniform layer (12) of a liquid source material having as a constituent a dopant of a second, opposite conductivity type as said substrates (2) move on said conveyor means (30) through said first processing chamber (58) ;
(e) means for maintaining said second processing chamber (60) at a preselected temperature so as to dry said layers (12) as said substrates (2) move on said conveyor means (30) through said second processing chamber (60) ;
(f) a firing chamber (100) ;
(g) means for conveying said substrates (2) carrying the dried layers (12) from said conveyor means (30) into, through and out of said firing chamber (100) ; and
(h) firing means in said firing chamber (100) for heating said substrates (2) carrying the dried layers (12) as they move through said firing chamber (100) at a temperature and for a time sufficient to cause diffusion of said dopant constituent of said dried layers (12) into said front surfaces (4) of said substrates (2) and to form p-n junctions (18) at substantially uniform depths relative to said front surfaces (4) of each of said substrates (2) ;
said apparatus being characterized in that :
(i) air conduit means (70) communicates with said first processing chamber (58) for admitting moisturized air thereinto ; and
(ii) first humidity sensor means (80) is disposed in said first processing chamber (58) for providing signals to a control means for control of the flow of moisturizing air through said air conduit means (70) proximate said spray device (90) so as to maintain the relative humidity in said first processing chamber (58) proximate said spray device (90) in a selected range.

15. The apparatus in accordance with claim 14 further characterized in that the spray device is adapted to atomize said liquid source material without the use of pressurized gas and to spray said liquid source material onto said front surfaces (4) of each of said substrates (2) in the form of a fog.

16. The apparatus in accordance with any of claims 14-15 further characterized by a first housing (38) comprising air conduit means (69, 76) for providing moisturized air to its interior, said housing containing said first processing chamber (58) and said second processing chamber (60).

17. The apparatus according to any of claims 14-16 further characterized in that said spray device (90) includes a nozzle (126) having a distal end defining a discharge orifice, and in that said nozzle (126) is contained within said first processing chamber (58).

18. The apparatus according to any of claims 14-17 further characterized in that said means for maintaining said second processing chamber (60) at a preselected temperature comprises moisturized, preselected temperature air conduit means (72) in communication with said second processing chamber, and in that second humidity sensor means (82) is disposed in said second processing chamber (60) for providing signals to a control means for control of the flow of moisturized air through said air conduit means (72) to control the relative humidity in said second processing chamber (60).

19. The apparatus of any of claims 14-18 further characterized by a third processing chamber (62) adjacent said second processing chamber (60) through which said conveyor means (30) extends, said third processing chamber (62) being adapted to receive said substrates (2) from said second processing chamber (60), and said third processing chamber (62) including means (74) for further drying said layers (12).

20. The apparatus in accordance with claim 19 further characterized in that said first processing chamber (58), said second processing chamber (60) and said third processing chamber (62) are disposed within the same housing (38).

21. The apparatus in accordance with claims 19 or 20 further characterized in that said means for further drying said layers (12) comprises moisturized, preselected temperature air conduit means (74) in communication with said third processing chamber (62), and in that third humidity sensing means (84) is disposed in said third processing chamber (62) for providing signals to a control means for control of the flow of moisturized air through said air conduit means (74) to control the relative humidity in said third processing chamber (62).

22. The apparatus in accordance with claims 16 or 20 further characterized in that said apparatus comprises exhaust means (42, 44) in communication with said housing (38) to draw therefrom excess of said liquid source material and air provided by said spray device (90) and said air conduit means (69, 70, 72, 74, 76) respectively.

## Patentansprüche

1. Verfahren zur Herstellung von p-n-Übergängen in Siliziumsubstraten zur Herstellung fotovoltaischer Siliziumzellen, wobei
a) eine Vielzahl von Siliziumsubstraten (2), von denen jede eine Vorderfläche (4) und eine Rückfläche (6) aufweist, in einer ersten Prozeßkammer (58) ausgerichtet wird, wobei die Substrate (2) vom Typ einer ersten Leitfähigkeit sind;
b) jede der besagten Vorderflächen (4) in der ersten Prozeßkammer (58) mittels einer Ultraschallsprüheinrichtung (90) mit einem flüssigen dotiermittelenthaltenden Material sprühbeschichtet wird zur Bildung einer Lage (12) des flüssigen dotiermittelenthaltenden Materials auf jeder der Vorderflächen (4) mit einer Dicke, die im wesentlichen geringer als die der Substrate (2) ist, wobei das Dotiermittel vom Typ einer zweiten gegensätzlichen Leitfähigkeit ist;
c) die Substrate (2) aus der ersten Prozeßkammer (58) entnommen und in eine zweite Prozeßkammer (60) gebracht werden;
d) die Lagen (12) in der zweiten Prozeßkammer (60) getrocknet werden, um einen dotiermittelenthaltenden Rückstand auf jeder der Vorderflächen (4) zu erhalten;
e) die Substrate (2) aus der zweiten Prozeßkammer (60) entfernt und zu einer Feuerkammer (100) gebracht werden, und wobei
f) die Substrate (2) in der Feuerkammer (100) in sauerstoffenthaltender Umgebung befeuert werden, um Diffusion des Dotiermittels aus den Rückständen in die Substrate (2) zu verursachen, um in den Substraten (2) einen Bereich der besagten zweiten gegensätzlichen Leitfähigkeit zu erhalten und einen p-n-Übergang (18) gegenüberliegend der Vorderfläche (4) **dadurch gekennzeichnet,** daß die relative Feuchtigkeit einer Luftatmosphäre in der ersten Prozeßkammer innerhalb eines vorgegebenen Bereichs gehalten wird.

2. Verfahren nach Anspruch 1, **dadurch gekennzeichnet,** daß beim Verfahrensschritt f) die Befeuerungstemperatur 890 °C beträgt.

3. Verfahren nach Anspruch 1, **dadurch gekennzeichnet,** daß die Substrate (2) durch die erste Prozeßkammer (58) entlang eines geradlinigen Wegs transportiert werden und daß die Ultraschallsprüheinrichtung (90) über die Substrate (2) quer zur Richtung, in der die Substrate (2) transportiert werden, hin- und hergefahren wird, wobei die Transportrate in der Größenordnung von ungefähr 48 vollständigen Einheiten pro Minute liegt.

4. Verfahren nach Anspruch 1, **dadurch gekennzeichnet,** daß jede Lage (12) mit einer Dicke zwischen ungefähr 0,1 µm und ungefähr 0,2 µm gebildet wird.

5. Verfahren nach Anspruch 1, **dadurch gekennzeichnet,** daß das Dotiermittel Phosphor ist.

6. Verfahren nach Anspruch 1, **dadurch gekennzeichnet,** daß
a) die Substrate (2) mit Bor dotiertes Silizium sind,
b) das flüssige dotiermittelenthaltende Material 1. Phosphor enthält, 2. auf die Substrate bei einer Temperatur zwischen 18,3 und 29,4 °C im Beisein von Luft mit einer relativen Feuchtigkeit von 25 bis 45 % aufgebracht wird und 3. bei einer Temperatur zwischen 18,3 und 29,4 °C für zwei bis fünf Minuten im Beisein von Luft mit einer relativen Feuchtigkeit von 25 bis 60 % getrocknet wird und wobei
c) die Substrate (2) bei einer Temperatur von ungefähr 890 °C während einer Zeit befeuert werden, die ausreicht zur Bildung von oberflächlichen p-n-Übergängen (18) durch Diffusion des Dotiermittels.

7. Verfahren nach Anspruch 6, **dadurch gekennzeichnet,** daß das Dotiermittel Phosphor ist und in die Vorderflächen (4) der Substrate (2) bis in eine Tiefe von ungefähr 0,5 µm diffundiert.

8. Verfahren nach Anspruch 6, **dadurch gekennzeichnet,** daß jede der Lagen (12) aus flüssigem dotiermittelenthaltenden Material eine Dicke zwischen ungefähr 100 und ungefähr 200 nm aufweist.

9. Verfahren nach Anspruch 1, **dadurch gekennzeichnet,** daß die Ultraschallsprüheinrichtung (90) eine Düse (126) enthält mit einem entfernten Ende zum Austrag eines im wesentlichen konischen Sprühmusters aus im wesentlichen µm-großen Tröpfchen, wobei das konische Sprühmuster einen Maximaldurchmesser von 0,318 cm in einer Entfernung von 0,635 cm vom entfernten Ende der Düse (126) aufweist, und wobei die Ultraschallsprüheinrichtung (90) mit einer Frequenz in der Größenordnung von 48 kHz betrieben wird, während die Substrate (2) mit einer Geschwindigkeit zwischen 12,7 und 254 cm/Minute relativ zur Düse (126) in einer ersten im wesentlichen horizontalliegenden Ebene derart gefördert werden, daß die Vorderflächen (4) der Substrate (2) zwischen 3,18 und 0,635 cm unterhalb des entfernten Endes der Düse (126) liegen und daß das entfernte Ende der Düse (126) über die Substrate (2) quer zu deren Transportrichtung in einer zweiten, im wesentlichen horizontalen Ebene mit einer Rate von ungefähr 48 vollständigen Zyklen pro Minute hin- und hergeführt wird.

10. Verfahren nach Anspruch 1, **dadurch gekennzeichnet,** daß
- die Siliziumsubstrate (2) flache Siliziumsubstrate sind,
- der Lieferschritt (a) durch Ablage der Vielzahl von flachen Siliziumsubstraten (2) auf einem Förderer (30) und durch Transport der Substrate (2) mittels des Förderers (30) in die erste Prozeßkammer (58) ausgeführt wird,
- die Ultraschallsprüheinrichtung (90) quer über die Substrate (2) mit einer Rate von 48 Zyklen/Minute in einer Ebene parallel zur Ebene, in der die Substrate (2) in der ersten Prozeßkammer (58) enthalten sind, hin- und hergeführt wird,
- die flüssige Lage (12) mit einer Dicke zwischen 100 und 200 nm aufgebracht wird,
- der Trockenschritt (d) bei einer Temperatur zwischen 18,3 und 29,4 °C in Luftatmosphäre mit einer relativen Feuchtigkeit, die zwischen 25 und 45 % gehalten wird, ausgeführt wird,
- im Lieferschritt (e) die Substrate (2) zu einem Infrarotofen (100) auf einem zweiten Förderer (14) geliefert werden, der den hohen Temperaturen standhält,
- im Schritt (f) die Befeuerung bei einer Temperatur und während einer Zeit ausgeführt wird, die das Dotiermittel zur Diffusion in die Substrate (2) in eine Tiefe von 0,5 µm veranlaßt und
- im Schritt (a) eine Luftatmosphäre in der ersten Prozeßkammer auf einer relativen Feuchtigkeit zwischen 25 und 45 % gehalten wird und im Schritt (b) die Sprühbeschichtung der Substrate in der ersten Prozeßkammer während der Aufrechterhaltung der relativen Feuchtigkeit in der ersten Prozeßkammer in besagtem Umfang ausgeführt wird.

11. Verfahren nach Anspruch 10, **dadurch gekennzeichnet,** daß die Substrate (2) mit Bor dotiert sind, wobei das flüssige Ausgangsmaterial Phosphor enthält und im Schritt (f) die Substrate (2) bei einer Temperatur von 880 bis 950 °C befeuert werden.

12. Verfahren nach Anspruch 10, **dadurch gekennzeichnet,** daß im Schritt (b) das flüssige dotiermittelenthaltende Material ein Phosphorsiliziumpolymer enthält.

13. Verfahren nach Anspruch 1, **dadurch gekennzeichnet,** daß der Lieferschritt (a) durch Ablage der Vielzahl von Siliziumsubstraten (2) auf einem Förderer (30) ausgeführt wird und wobei die Substrate (2) über den Förderer (30) in eine erste Prozeßkammer (58) transportiert werden, wobei der Förderer (30) mit flüssigkeitsabsorbierenden Oberflächenbereichen ausgestattet ist und jedes der Substrate (2) so abgelegt wird, daß die Rückenfläche (6) in Kontakt mit einer der flüssigkeitabsorbierenden Oberflächenbereiche des Förderers (30) ist.

14. Vorrichtung zur Bildung von oberflächlichen p-n-Übergängen in Siliziumsubstraten zur Herstellung von fotovoltaischen Siliziumzellen, wobei jedes der Substrate vom Typ einer ersten Konduktivität ist und eine Vorderfläche (4) und eine Rückenfläche (6) aufweist, mit
a) einer ersten Prozeßkammer (58) und
b) einer zweiten Prozeßkammer (60) gegenüberliegend der ersten Prozeßkammer (58),
c) Fördermitteln (30) zur Aufnahme der Substrate (2) auf deren Rückenfläche (6) und zum sequentiellen Bewegen der Substrate in die, durch die und aus der erste(n) Prozeßkammer (58) heraus in eine zweite Prozeßkammer (60),
d) einer Ultraschallsprüheinrichtung (90), die wenigstens teilweise in der ersten Prozeßkammer (58) angeordnet ist, welche zum Sprühbeschichten der Vorderflächen (4) jedes der Substrate (2) mit einer ununterbrochenen und im wesentlichen einheitlichen Lage (12) aus einem flüssigen Ausgangsmaterial vorgesehen ist, welches im wesentlichen ein Dotiermittel einer zweiten Leitfähigkeit entgegengesetzten Typs enthält, während sich die Substrate (2) auf den Fördermitteln (30) durch die erste Prozeßkammer (58) bewegen;
e) Mitteln zur Aufrechterhaltung einer vorbestimmten Temperatur in der zweiten Prozeßkammer (60), um die Lagen (12) zu trocknen, während die Substrate (2) auf dem Förderer (30) durch die zweite Prozeßkammer (60) bewegt werden;
f) einer Befeuerungskammer (100);
g) Mitteln zur Förderung der Substrate (2), welche die getrockneten Lagen (12) tragen, von dem Förderer (30) in die, durch die und aus der Feuerkammer (100) heraus, und mit
h) Befeuerungsmitteln in der Befeuerungskammer (100) zur Aufheizung der Substrate (2), welche die getrockneten Lagen (12) während der Bewegung durch die Befeuerungskammer (100) bei einer Temperatur und während einer Zeit tragen, die ausreicht, um das Dotiermittel der besagten trockenen Lagen (12) zur Diffusion in die Vorderflächen (4) der Substrate (2) zu veranlassen, um p-n-Übergänge (18) im wesentlichen gleicher Tiefe bezüglich der Vorderflächen (4) jedes der Substrate (2) zu bilden; **dadurch gekennzeichnet,** daß
i) Luftleitmittel (70) mit der ersten Prozeßkammer (58) kommunizieren, um angefeuchtete Luft dort einzulassen und daß
ii) ein erster Feuchtigkeitssensor (80) in der ersten Prozeßkammer (58) angeordnet wird, zur Erzeugung von Signalen für eine Steuereinrichtung zum Steuern des Durchflusses befeuchtender Luft durch die Luftleitmittel (70) benachbart zu der Sprüheinrichtung (90), um die relative Feuchtigkeit in der ersten Prozeßkammer (58) benachbart zur Sprüheinrichtung (90) in einem vorbestimmten Bereich zu halten.

15. Vorrichtung nach Anspruch 14, **dadurch gekennzeichnet,** daß die Sprüheinrichtung zur Atomisierung des flüssigen Ausgangsmaterials ohne Verwendung von Druckgas ausgelegt ist und dazu, um das flüssige Ausgangsmaterial auf die Vorderfläche (4) jedes der Substrate (2) in Form eines Nebels zu sprühen.

16. Vorrichtung nach einem der Ansprüche 14 bis 15, **dadurch gekennzeichnet,** daß ein erstes Gehäuse (38) Luftleitmittel (69,76) enthält, die befeuchtete Luft zu dessen Inneren führen, wobei das Gehäuse die erste Prozeßkammer (58) und die zweite Prozeßkammer (60) enthält.

17. Vorrichtung nach einem der Ansprüche 14 bis 16, **dadurch gekennzeichnet,** daß die Sprüheinrichtung (90) eine Düse (126) umfaßt, die an einem entfernten Ende eine Austragsöffnung aufweist, und daß die Düse (126) innerhalb der ersten Prozeßkammer (58) enthalten ist.

18. Vorrichtung nach einem der Ansprüche 14 bis 17, **dadurch gekennzeichnet,** daß die Mittel zur Aufrechterhaltung einer vorgegebenen Temperatur in der zweiten Prozeßkammer (60) Luftleitmittel (72) zur Befeuchtung mit vorbestimmter Temperatur enthalten, die mit der zweiten Prozeßkammer kommunizieren und dadurch, daß zweite Feuchtigkeitssensoren (82) in der zweiten Prozeßkammer (60) zur Erzeugung von Signalen für eine Steuereinrichtung vorgesehen sind, welche den Durchfluß der befeuchteten Luft durch die Luftleitmittel (72) steuern, um die relative Feuchtigkeit in der zweiten Prozeßkammer (60) zu steuern.

19. Vorrichtung nach einem der Ansprüche 14 bis 18, **dadurch gekennzeichnet,** daß eine dritte Prozeßkammer (62) gegenüber der zweiten Prozeßkammer (60) vorgesehen ist, durch welche die Fördermittel (30) sich erstrecken, wobei die dritte Prozeßkammer (62) zur Aufnahme der Substrate (2) aus der zweiten Prozeßkammer (60) ausgelegt ist und Mittel (74) zur weiteren Trocknung der Lagen (12) enthält.

20. Vorrichtung nach Anspruch 19, **dadurch gekennzeichnet,** daß die erste Prozeßkammer (58), die zweite Prozeßkammer (60) und die dritte Prozeßkammer (62) innerhalb desselben Gehäuses (38) angeordnet sind.

21. Vorrichtung nach einem der Ansprüche 19 oder 20, **dadurch gekennzeichnet,** daß die Mittel zur weiteren Trocknung der Lagen (12) Luftleiteinrichtungen (74) für befeuchtete Luft vorbestimmter Temperatur enthalten, die mit der dritten Prozeßkammer (62) kommunizieren und daß dritte Feuchtigkeitssensoren (84) in der dritten Prozeßkammer (62) angeordnet sind, um Signale an eine Steuereinrichtung zum Steuern des Durchflusses von befeuchteter Luft durch die Luftleiteinrichtungen (74) zur erzeugen, um die relative Feuchtigkeit in der dritten Prozeßkammer (62) zu steuern.

22. Vorrichtung nach einem der Ansprüche 16 oder 20, **dadurch gekennzeichnet,** daß Abluftmittel (42,44) mit dem Gehäuse (38) kommunizieren, um dort einen Überschuß an flüssigem Ausgangsmaterial und Luft, die durch die Sprüheinrichtung (90) und die Luftleitmittel (69,70,72, 74,76) erzeugt wurde, abzuziehen.

## Revendications

1. Procédé de formation de jonctions PN dans des substrats en silicium pour réaliser des cellules photovoltaiques au silicium, comprenant les étapes qui consistent à :
(a) délivrer de multiples substrats en silicium (2) qui possèdent chacun une face avant (4) et une face arrière (6) dans une première chambre de traitement (58), lesdits substrats (2) ayant un premier type de conductivité;
(b) revêtir par pulvérisation chacune desdites faces avant (4) dans ladite première chambre de traitement (58) avec une substance liquide contenant un agent de dopage à l'aide d'un dispositif de pulvérisation ultrasonique (90) afin de former sur chacune desdites faces avant (4) une couche (12) de ladite substance liquide contenant l'agent de dopage, ayant une épaisseur sensiblement inférieure à celle des substrats (2), ledit agent de dopage ayant un second type de conductivité inverse;
(c) extraire lesdits substrats (2) de ladite première chambre de traitement (58) et les délivrer à une seconde chambre de traitement (60);
(d) sécher lesdites couches (12) dans ladite seconde chambre de traitement (60) afin de laisser un résidu contenant l'agent de dopage sur chacune desdites faces avant (4) ;
(e) extraire lesdits substrats (2) de ladite seconde chambre de traitement (60) et les délivrer à une chambre de cuisson (100); et
(f) cuire lesdits substrats (2) dans ladite chambre de cuisson (100) dans un environnement contenant de l'oxygène pour provoquer la diffusion dudit agent de dopage depuis lesdits résidus dans lesdits substrats (2) afin de former dans chacun desdits substrats (2) une zone ayant ledit second type de conductivité inverse, et une jonction PN (18) à proximité de ladite face avant (4);
ledit procédé étant caractérisé par le maintien de l'humidité relative d'une atmosphère d'air dans ladite première chambre de traitement à l'intérieur d'une plage présélectionnée.

2. Procédé selon la revendication 1, suivant lequel l'étape (f) est exécutée à une température de cuisson de 890 degrés C.

3. Procédé selon la revendication 1, suivant lequel lesdits substrats (2) sont transportés à travers ladite première chambre de traitement (58) le long d'une trajectoire rectiligne, et ledit dispositif de pulvérisation ultrasonique (90) est déplacé suivant un mouvement de va-et-vient d'un bout à l'autre desdits substrats (2), transversalement au sens dans lequel ces derniers sont transportés, à une cadence de l'ordre d'environ 48 courses complètes par minute.

4. Procédé selon la revendication 1, suivant lequel chacune desdites couches (12) est formée pour avoir une épaisseur entre environ 0,1 micromètre et environ 0,2 micromètre.

5. Procédé selon la revendication 1, suivant lequel ledit agent de dopage est du phosphore.

6. Procédé selon la revendication 1, suivant lequel :
(a) lesdits substrats (2) sont en silicium dopé au bore,
(b) ladite substance liquide contenant l'agent de dopage (1) comprend du phosphore, (2) est appliquée auxdits substrats à une température de 18,3-29,4 degrés C en présence d'air ayant une humidité relative de 25-45%, et (3) est séchée à une température entre 18,3 et 29,4 degrés C pendant une période de temps représentant entre 2 et 5 minutes en présence d'air ayant une humidité relative de 25-60%, et
(c) lesdits substrats (2) sont cuits à une température d'environ 890 degrés C pendant une durée suffisante pour former une jonction PN (18) peu profonde par diffusion dudit agent de dopage.

7. Procédé selon la revendication 6, suivant lequel ledit agent de dopage est du phosphore et est diffusé dans lesdites faces avant (4) desdits substrats (2) jusqu'à une profondeur d'environ 0,5 micromètre.

8. Procédé selon la revendication 6, suivant lequel chacune desdites couches (12) de la substance liquide contenant l'agent de dopage a une épaisseur entre environ 100 et environ 200 nanomètres.

9. Procédé selon la revendication 1, suivant lequel ledit dispositif ultrasonique (90) comprend une buse (126) qui possède une extrémité distale adaptée pour émettre un jet de configuration sensiblement conique formé de gouttelettes ayant une taille sensiblement micrométrique, jet de configuration conique qui a un diamètre maximal de 0,318 cm à une distance de 0,635 cm de ladite extrémité distale de ladite buse (126), ledit dispositif de pulvérisation ultrasonique (90) étant actionné à une fréquence de l'ordre de 48 kHz, et lesdits substrats (2) étant transportés à une vitesse entre 12,7 et 254 cm par minute par rapport à ladite buse (126) dans un premier plan sensiblement horizontal de façon que lesdites surfaces avant (4) desdits substrats (2) soient situées entre 3,18 et 0,635 cm au-dessous de ladite extrémité distale de ladite buse (126), et ladite extrémité distale de ladite buse (126) est déplacée suivant un mouvement de va-et-vient d'un bout à l'autre desdits substrats (2), transversalement au sens de transport de ces derniers dans un second plan sensiblement horizontal à une cadence d'environ 48 cycles complets par minute.

10. Procédé selon la revendication 1, caractérisé en ce que :
- lesdits substrats en silicium (2) sont des substrats en silicium plans,
- l'étape de livraison (a) s'effectue en plaçant lesdits multiples substrats en silicium (2) plans sur un transporteur (30) et en transportant lesdits substrats (2) par l'intermédiaire dudit transporteur (30) jusque dans ladite première chambre de traitement (58),
- ledit dispositif de pulvérisation ultrasonique (90) est déplacé suivant un mouvement de va-et-vient transversalement d'un bout à l'autre desdits substrats (2) à une cadence de 48 cycles par minute dans un plan parallèle au plan qui contient lesdits substrats (2) dans ladite première chambre de traitement (58),
- la couche liquide (12) est appliquée sur une épaisseur entre 100 et 200 nanomètres,
- ladite étape de séchage (d) est exécutée à une température entre 18,3 et 29,4° C dans une atmosphère d'air ayant une humidité relative maintenue entre 25% et 45%,
- au cours de ladite étape de livraison (e), lesdits substrats (2) sont délivrés à un four infrarouge (100) sur un second transporteur (14) adapté pour résister à des températures élevées,
- au cours de ladite étape (f), ladite cuisson est réalisée à une température et pendant une période de temps suffisantes pour obliger ledit agent de dopage à diffuser dans lesdits substrats (2) jusqu'à une profondeur de 0,5 micromètres, et
- au cours de l'étape (a), une atmosphère d'air est maintenue dans ladite première chambre de traitement (58) avec une humidité relative de 25% à 45%, et au cours de l'étape (b), le revêtement par pulvérisation desdits substrats dans ladite première chambre de traitement s'effectue en maintenant ladite humidité relative au sein de ladite chambre dans ladite plage.

11. Procédé selon la revendication 10, suivant lequel lesdits substrats (2) sont dopés avec du bore, ladite substance liquide source comprend du phosphore, et au cours de l'étape (f) lesdits substrats (2) sont cuits à une température de 880-950 degrés C.

12. Procédé selon la revendication 10, suivant lequel au cours de l'étape (b) ladite substance liquide contenant l'agent de dopage comprend un polymère de phosphosilicate.

13. Procédé selon la revendication 1, suivant lequel l'étape de livraison (a) s'effectue en plaçant lesdits multiples substrats en silicium (2) sur un transporteur (30) et en transportant lesdits substrats (2) par l'intermédiaire dudit transporteur (30) jusque dans ladite première chambre de traitement (58), ledit transporteur (30) étant pourvu de parties de surface absorbantes de liquide et chacun desdits substrats (2) étant placé de façon que ladite face arrière (6) soit en contact avec l'une desdites parties de surface absorbantes de liquide dudit transporteur (30).

14. Appareil pour former des jonctions PN peu profondes dans des substrats en silicium (2) afin de réaliser des cellules photovoltaïques au silicium, chacun desdits substrats (2) ayant un premier type de conductivité et possédant une face avant (4) et une face arrière (6), ledit appareil comprenant :
(a) une première chambre de traitement (58);
(b) une seconde chambre de traitement (60) adjacente à ladite première chambre de traitement (58);
(c) un moyen transporteur (30) destiné à supporter lesdits substrats (2) sur les faces arrière (6) de ceux-ci et à les transporter successivement dans, à travers et hors de ladite première chambre de traitement (58) et de ladite seconde chambre de traitement (60);
(d) un dispositif de pulvérisation ultrasonique (90) disposé au moins partiellement dans ladite première chambre de traitement (58), ledit dispositif de pulvérisation (90) étant adapté pour revêtir par pulvérisation les faces avant (4) de chacun desdits substrats (2) d'une couche continue, sensiblement uniforme (12) d'une substance liquide source comportant comme constituant un agent de dopage ayant un second type de conductivité inverse pendant que lesdits substrats (2) se déplacent sur ledit moyen transporteur (30) à travers ladite première chambre de traitement (58);
(e) un moyen pour maintenir ladite seconde chambre de traitement (60) à une température présélectionnée afin de sécher lesdites couches (12) pendant que les substrats (2) se déplacent sur ledit moyen transporteur (30) à travers ladite seconde chambre de traitement (60);
(f) une chambre de cuisson (100);
(g) un moyen pour acheminer lesdits substrats (2) portant les couches (12) séchées depuis ledit moyen transporteur (30) dans, à travers et hors de ladite chambre de cuisson (100); et
(h) un moyen de cuisson prévu dans ladite chambre de cuisson (100) pour chauffer lesdits substrats (2) porteurs des couches (12) séchées pendant qu'ils se déplacent à travers ladite chambre de cuisson (100) à une température et pendant une durée suffisantes pour provoquer une diffusion dudit constituant dopant depuis lesdites couches (12) séchées dans lesdites faces avant (4) desdits substrats (2) et pour former des jonctions PN (18) à des profondeurs sensiblement uniformes par rapport auxdites faces avant (4) de chacun desdits substrats (2);
ledit appareil étant caractérisé en ce que :
(i) un moyen formant conduit d'air (70) communique avec ladite première chambre de traitement (58) pour y admettre de l'air humidifié; et
(ii) un premier moyen détecteur d'humidité (80) est disposé dans ladite première chambre de traitement (58) pour fournir des signaux à un moyen de commande destiné à commander le flux d'air humidificateur à travers ledit moyen formant conduit d'air (70) à proximité dudit dispositif de pulvérisation (90) afin de maintenir l'humidité relative dans ladite première chambre de traitement (58) à proximité dudit dispositif de pulvérisation (90) dans une plage sélectionnée.

15. Appareil selon la revendication 14, également caractérisé en ce que le dispositif de pulvérisation est adapté pour atomiser ladite substance liquide source sans l'utilisation d'un gaz sous pression et pour pulvériser ladite substance liquide source sur lesdites faces avant (4) de chacun desdits substrats (2) sous la forme d'un brouillard.

16. Appareil selon la revendication 14 ou 15, également caractérisé par un premier logement (38) qui comprend des moyens formant conduits d'air (69, 76) destinés à fournir de l'air humidifié à l'intérieur de celui-ci, ledit logement contenant ladite première chambre de traitement (58) et ladite seconde chambre de traitement (60).

17. Appareil selon l'une quelconque des revendications 14 à 16, également caractérisé en ce que ledit dispositif de pulvérisation (90) comprend une buse (126) ayant une extrémité distale qui définit un orifice de sortie, et en ce que ladite buse (126) est contenue à l'intérieur de ladite première chambre de traitement (58).

18. Appareil selon l'une quelconque des revendications 14 à 17, également caractérisé en ce que ledit moyen pour maintenir ladite seconde chambre de traitement (60) à une température présélectionnée comprend un moyen formant conduit (72) d'air humidifié, à une température présélectionnée en communication avec ladite seconde chambre de traitement, et en ce que ledit second moyen détecteur d'humidité (82) est disposé dans ladite seconde chambre de traitement (60) pour fournir des signaux à un moyen de commande destiné à commander le flux d'air humidifié à travers ledit moyen formant conduit d'air (72) en vue de contrôler l'humidité relative dans ladite seconde chambre de traitement (60).

19. Appareil selon l'une quelconque des revendications 14 à 18, également caractérisé par une troisième chambre de traitement (62) adjacente à ladite seconde chambre de traitement (60), à travers laquelle s'étend ledit moyen transporteur (30), ladite troisième chambre de traitement (62) étant adaptée pour recevoir lesdits substrats (2) provenant de ladite seconde chambre de traitement (60), et ladite troisième chambre de traitement (62) comprenant un moyen (74) pour continuer à sécher lesdites couches (12).

20. Appareil selon la revendication 19, également caractérisé en ce que ladite première chambre de traitement (58), ladite seconde chambre de traitement (60) et ladite troisième chambre de traitement (62) sont disposées à l'intérieur du même logement (38).

21. Appareil selon la revendication 19 ou 20, également caractérisé en ce que ledit moyen pour continuer à sécher lesdites couches (12) comprend un moyen formant conduit (74) d'air humidifié, à une température présélectionnée en communication avec ladite troisième chambre de traitement (62), et en ce qu'un troisième moyen détecteur d'humidité (84) est disposé dans ladite troisième chambre de traitement (62) pour fournir des signaux à un moyen de commande destiné à commander le flux d'air humidifié à travers ledit moyen formant conduit d'air (74) afin de contrôler l'humidité relative dans ladite troisième chambre de traitement (62).

22. Appareil selon la revendication 16 ou 20, également caractérisé en ce que ledit appareil comprend des moyens d'évacuation (42, 44) en communication avec ledit logement (38) pour extraire de celui-ci un surplus de ladite substance liquide source et d'air fournis par ledit dispositif de pulvérisation (90) et lesdits moyens formant conduits d'air (69, 70, 72, 74, 76), respectivement.
